(19) Europäisches Patentamt

European Patent Office

Office européen des brevets

(11) **EP 3 892 753 A1**

(12) # EUROPEAN PATENT APPLICATION
published in accordance with Art. 153(4) EPC

(43) Date of publication:
**13.10.2021 Bulletin 2021/41**

(21) Application number: **19894248.4**

(22) Date of filing: **05.12.2019**

(51) Int Cl.:
*C23C 14/14* [(2006.01)]  *C22C 5/06* [(2006.01)]
*C23C 14/34* [(2006.01)]  *G02F 1/1335* [(2006.01)]
*G02F 1/1343* [(2006.01)]  *C22F 1/00* [(2006.01)]
*C22F 1/14* [(2006.01)]

(86) International application number:
**PCT/JP2019/047603**

(87) International publication number:
**WO 2020/116557 (11.06.2020 Gazette 2020/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.12.2018 JP 2018228365**

(71) Applicant: **Mitsubishi Materials Corporation Tokyo 100-8117 (JP)**

(72) Inventors:
• **TOSHIMORI Yuto**
  **Naka-shi, Ibaraki 311-0102 (JP)**
• **NONAKA Sohei**
  **Naka-shi, Ibaraki 311-0102 (JP)**
• **KOMIYAMA Shozo**
  **Sanda-shi, Hyogo 669-1339 (JP)**
• **HAYASHI Yujiro**
  **Sanda-shi, Hyogo 669-1339 (JP)**

(74) Representative: **Hoffmann Eitle Patent- und Rechtsanwälte PartmbB Arabellastraße 30 81925 München (DE)**

(54) **METAL FILM AND SPUTTERING TARGET**

(57)    In the metal film, a Pd content is 40 mass ppm or less, a Pt content is 20 mass ppm or less, a Au content is 20 mass ppm or less, a Rh content is 10 mass ppm or less, a total amount of Pd, Pt, Au, and Rh is 50 mass ppm or less, and a balance consists of Ag and inevitable impurities.

## FIG. 1

EP 3 892 753 A1

**Description**

[Technical Field]

The present invention relates to a metal film used, for example, as a reflective film, an electrode film, or a wiring film, and a sputtering target used when depositing this metal film.

This application claims priority based on Japanese Patent Application No. 2018-228365, filed in Japan on December 5, 2018, the contents of which are hereby incorporated herein by reference.

[Background Art]

For example, as a reflective film, an electrode film, or a wiring film of a display device such as a liquid crystal display, an organic EL display, or a touch panel, for instance, the use of a metal film formed of Ag or an Ag alloy is proposed, as shown in

Patent Document 1.

In addition, in Patent Documents 2 to 4, a multilayer film is proposed which is a laminated structure of a transparent conductive oxide film and a metal film formed of Ag or an Ag alloy.

In the reflective film, electrode film, and wiring film described above, as shown in the Patent Documents 1 to 4 described above, a predetermined pattern shape may be formed, for example, by a wet etching treatment using an etchant (referred to below as an etching treatment).

Here, in general, in a case of carrying out an etching treatment on a metal film formed of Ag or an Ag alloy, for example, an etchant including nitric acid, such as PAN (phosphoric acid + nitric acid + acetic acid), is used.

However, in a case of carrying out an etching treatment on a metal film formed of Ag or an Ag alloy with an etchant including nitric acid, it may be difficult to control the etching state with good precision since the dissolution rate of Ag is extremely fast.

In addition, in a case of carrying out an etching treatment on a multilayer film of a transparent conductive oxide film and a metal film with an etchant including nitric acid, there is a problem in that there is a large difference in etching rate between the transparent conductive oxide film and the metal film, the metal film is over-etched, and it is not possible to form a pattern shape with good precision after the etching.

Here, Patent Document 2 proposes a method for suppressing over-etching of a metal film by using an oxalic acid etchant.

In addition, Patent Document 3 and 4 propose a method for suppressing over-etching of a metal film by specifying the composition of a transparent conductive oxide film to reduce the difference in etching rate between the transparent conductive oxide film and the metal film.

[Citation List]

[Patent Documents]

[Patent Document 1]
Japanese Unexamined Patent Application, First Publication No. 2006-028641 (A)
[Patent Document 2]
Japan Patent (Granted) Publication No. 6020750 (B)
[Patent Document 3]
Japanese Unexamined Patent Application, First Publication No. 2017-179594 (A)
[Patent Document 4]
Japanese Unexamined Patent Application, First Publication No. 2017-183274 (A)

[Summary of Invention]

[Technical Problem]

Here, in a step of carrying out an etching treatment on a metal film formed of Ag or an Ag alloy, since etchants including nitric acid such as PAN have been widely used for some time as described above, there is a demand to carry out an etching treatment with good precision using an etchant including nitric acid.

In addition, depending on the characteristics demanded for the multilayer film, the transparent conductive oxide film described in Patent Document 3 and 4 may not be applicable.

Therefore, there is a demand for a metal film for which it is possible to control the etching rate even in a case where an etchant including nitric acid, such as PAN, is used.

This invention was created in consideration of the circumstances described above and has an object of providing a metal film for which it is possible to control the etching rate even in a case of using an etchant including nitric acid and with which it is possible to carry out an etching treatment with good precision, and a sputtering target used when depositing this metal film.

[Solution to Problem]

In order to solve the problems described above, the present inventors obtained the following findings as a result of intensive research.

When carrying out an etching treatment on a metal film formed of Ag or an Ag alloy using an etchant including nitric acid, a dissolution reaction of Ag and a reduction reaction of nitric acid are performed. At this time, when the reduction reaction of nitric acid is promoted, the dissolution reaction of Ag is also promoted and the etching rate of the metal film becomes faster. Therefore, by limiting the amounts of elements such as Pd, Pt, Au, and Rh, which act as catalysts in the reduction reaction of nitric acid, it is possible to control the etching rate of the metal film even when using an etchant containing nitric acid.

The present invention is based on the findings described above and the metal film of the present invention is a metal film wherein a Pd content is 40 mass ppm or less, a Pt content is 20 mass ppm or less, a Au content is 20 mass ppm or less, a Rh content is 10 mass ppm or less, a total amount of Pd, Pt, Au, and Rh is 50 mass ppm or less, and a balance consists of Ag and inevitable impurities.

In the metal film of this configuration, since the amounts of Pd, Pt, Au, and Rh, which act as catalysts in the reduction reaction of nitric acid, are limited as described above, even in a case where an etching treatment is carried out using an etchant including nitric acid, it is possible to suppress the dissolution reaction of Ag from progressing more than is necessary and to control the etching rate.

Therefore, even when carrying out an etching treatment with an etchant including nitric acid, it is possible to stably control the etching state and to form a pattern shape with good precision.

Here, the metal film of the present invention may include one or more of Sb, Zn, Sn, Pb, and Ti in a range of 0.05 atom% or more and 5.00 atom% or less in total as additive elements.

Since Sb, Zn, Sn, Pb, and Ti act as catalytic poisons which control the reduction reaction of nitric acid, containing these additive elements in the range described above makes it possible to further control the reduction reaction of nitric acid and to further control the etching rate of the metal film.

In addition, the sputtering target of the present invention is a sputtering target, wherein a Pd content is 40 mass ppm or less, a Pt content is 20 mass ppm or less, a Au content is 20 mass ppm or less, a Rh content is 10 mass ppm or less, a total amount of Pd, Pt, Au, and Rh is 50 mass ppm or less; and a balance consists of Ag and inevitable impurities.

In the sputtering target of this configuration, since the amounts of Pd, Pt, Au, and Rh, which act as catalysts in the reduction reaction of nitric acid, are limited as described above, it is also possible to limit the amounts of Pd, Pt, Au, and Rh in the deposited metal film and to deposit a metal film for which it is possible to control the etching rate, even when carrying out an etching treatment using an etchant including nitric acid.

Here, the sputtering target of the present invention may include one or more of Sb, Zn, Sn, Pb, and Ti in a range of 0.05 atom% or more and 5.00 atom% or less in total as additive elements.

In this case, since Sb, Zn, Sn, Pb, and Ti, which act as catalytic poisons to suppress the reduction reaction of nitric acid, are contained, the deposited metal film also contains these additive elements in the range described above, which makes it possible to further suppress the reduction reaction of nitric acid and to deposit a metal film for which it is possible to control the etching rate, even when carrying out an etching treatment using an etchant including nitric acid.

In addition, in the sputtering target of the present invention, a distribution $D_T = (\sigma_T/\mu_T) \times 100$ (%) may be 20% or less, the Distribution $D_T$ being calculated from an average value $\mu_T$ and a standard deviation $\sigma_T$ of total amount values of Sb, Zn, Sn, Pb, and Ti at a plurality of measurement points on a sputtering surface.

In a case where additive elements such as Sb, Zn, Sn, Pb, and Ti are included, since the distribution $D_T$ calculated from the average value $\mu_T$ and the standard deviation $\sigma_T$ of total amount values of additive elements at a plurality of measurement points on a sputtering surface is controlled to be 20% or less, these additive elements are uniformly present on the sputtering surface and it is possible to stably deposit a metal film in which these additive elements are uniformly dispersed.

[Advantageous Effects of Invention]

According to the present invention, it is possible to provide a metal film for which it is possible to control the etching rate even in a case of using an etchant including nitric acid and with which it is possible to carry out an etching treatment with good precision, and a sputtering target used when depositing this metal film.

[Brief Description of Drawings]

Fig. 1 is an explanatory diagram showing measurement positions of the amounts of additive elements on a sputtering surface in a rectangular flat plate type sputtering target.
Fig. 2 is an explanatory diagram showing measurement positions of the amounts of additive elements on a sputtering surface in a circular plate type sputtering target.
Fig. 3A is an explanatory diagram showing measurement positions of the amounts of additive elements on a sputtering surface in a cylindrical type sputtering target and a cross-sectional view perpendicular to the axis thereof.
Fig. 3B is an explanatory diagram showing measurement positions of the amounts of additive elements on a sputtering surface in a cylindrical type sputtering target and a cross-sectional view along the axis thereof.

[Description of Embodiments]

A description will be given of a metal film and a sputtering target which are embodiments of the present invention.
The metal film of the present embodiment is used as a reflective film, electrode film, or wiring film for display devices such as liquid crystal displays, organic EL displays, and touch panels.

<Metal Film>

In the metal film of an embodiment of the present invention, the composition is formed of Pd content of 40 mass ppm or less, Pt content of 20 mass ppm or less, Au content of 20 mass ppm or less, Rh content of 10 mass ppm or less, the total amount of Pd, Pt, Au, and Rh being 50 mass ppm or less and the balance consisting of Ag and inevitable impurities.
In the metal film of the present embodiment, at least one or more of Sb, Zn, Sn, Pb, and Ti as additive elements may be further contained in a range of 0.05 atom% or more and 5.00 atom% or less in total.
Here, a description will be given of the reasons for specifying the component composition in the metal film of the present embodiment as described above.

(Pd, Pt, Au, Rh)

The elements such as Pd, Pt, Au, and Rh described above act as catalysts in the reduction reaction of nitric acid and promote the reduction reaction of nitric acid. As a result, the dissolution reaction of Ag is promoted, thus, the etching rate of the metal film becomes faster.
Therefore, by limiting the amounts of Pd, Pt, Au, and Rh as described above, it is possible to suppress the etching rate of the metal film even when using an etchant including nitric acid.
Here, the Pd content is preferably 10 mass ppm or less, the Pt content is preferably 5 mass ppm or less, the Au content is preferably 5 mass ppm or less, and the Rh content is preferably 2 mass ppm or less. Furthermore, the total amount of Pd, Pt, Au, and Rh is preferably 10 mass ppm or less.
Although not particularly limited, the lower limit value of each amount of Pd, Pt, Au, and Rh in the metal film may be set to more than 0.1 mass ppm. In addition, the lower limit value of the total amount of Pd, Pt, Au, and Rh may be set to more than 0.5 mass ppm.

(Sb, Zn, Sn, Pb, Ti)

The additive elements (Sb, Zn, Sn, Pb, Ti) described above act as catalytic poisons in the reduction reaction of nitric acid and suppress the reduction reaction of nitric acid and thus may be appropriately added as necessary.
Here, by setting the total amount of Sb, Zn, Sn, Pb, and Ti to 0.05 atom% or more, it is possible to sufficiently suppress the reduction reaction of nitric acid and to further control the etching rate of the metal film even when using etchant including nitric acid. On the other hand, by setting the total amount of Sb, Zn, Sn, Pb, and Ti to 5.00 atom% or less, it is possible to suppress significant changes in the characteristics of the metal film.
Accordingly, in a case where the additive elements (Sb, Zn, Sn, Pb, and Ti) described above are added in the present embodiment, the total amount of the additive elements (Sb, Zn, Sn, Pb, and Ti) is in the range of 0.05 atom% or more and 5.00 atom% or less.

Here, the lower limit of the total amount of the additive elements (Sb, Zn, Sn, Pb, Ti) described above is preferably 0.10 atom% or more, and more preferably 0.20 atom% or more. In addition, the upper limit of the total amount of the additive elements (Sb, Zn, Sn, Pb, Ti) is preferably 4.00 atom% or less, and more preferably 3.00 atom% or less.

Here, in a case where the additive elements (Sb, Zn, Sn, Pb, Ti) described above are not intentionally added, the additive elements described above may be contained as less than 0.05 atom% in total as impurities.

<Sputtering Target>

Next, a description will be given of the sputtering target of the present embodiment. This sputtering target is used for depositing the metal film of the present embodiment described above.

In the sputtering target of the present embodiment, the composition is formed of Pd content of 40 mass ppm or less, Pt content of 20 mass ppm or less, Au content of 20 mass ppm or less, Rh content of 10 mass ppm or less, the total amount of Pd, Pt, Au, and Rh being 50 mass ppm or less and the balance consisting of Ag and inevitable impurities.

Although not particularly limited, the lower limit value of each of Pd, Pt, Au and Rh in the sputtering target may be set to more than 0.1 mass ppm.

In the sputtering target of the present embodiment, at least one or more of Sb, Zn, Sn, Pb, and Ti as additive elements may be contained in a range of 0.05 atom% or more and 5.00 atom% or less in total.

In the sputtering target of the present embodiment, in a case where at least one or more of Sb, Zn, Sn, Pb, and Ti as additive elements are contained in a range of 0.05 atom% or more and 5.00 atom% or less in total, the distribution $D_T$ calculated by the following formula from the average value $\mu_T$ and the standard deviation $\sigma_T$ of the total amount values of the additive elements (Sb, Zn, Sn, Pb, Ti) at a plurality of measurement points on the sputtering surface is preferably 20% or less.

$$D_T = (\sigma_T/\mu_T) \times 100 \ (\%)$$

Here, an explanation will be given of the reason why the component composition and the distribution of the additive elements are specified as described above in the sputtering target of the present embodiment.

(Component Composition)

In the sputtering target of the present embodiment, since the metal film described above is deposited, the component composition is set according to that of the metal film described above.

Thus, in the sputtering target of the present embodiment, in order to deposit a metal film for which the etching rate is suppressed as described above, the amounts of Pd, Pt, Au, and Rh, which are elements which act as catalysts in the reduction reaction of nitric acid, is limited.

In addition, in a case of containing additive elements (Sb, Zn, Sn, Pb, Ti) which act as catalytic poisons in the reduction reaction of nitric acid, the total amount of these additive elements is specified in the ranges described above.

(Distribution of Additive Elements (Sb, Zn, Sn, Pb, Ti))

In a case where the additive elements (Sb, Zn, Sn, Pb, Ti) described above are contained in the sputtering target of the present embodiment, the deposited metal film will also contain the additive elements described above.

Here, by setting the distribution $D_T$ calculated from the average value $\mu_T$ and the standard deviation $\sigma_T$ of the total amount values of the additive elements (Sb, Zn, Sn, Pb, Ti) at a plurality of measurement points on the sputtering surface to be 20% or less, these additive elements are uniformly present on the sputtering surface, it is possible to deposit a metal film in which these additive elements are uniformly dispersed, and the etching rate is stabilized over the entire metal film.

The distribution $D_T$ calculated from the average value $\mu_T$ and the standard deviation $\sigma_T$ of the total amount values of the additive elements (Sb, Zn, Sn, Pb, Ti) is preferably set to 15% or less, and more preferably 10% or less.

Although not particularly limited, the lower limit value of the distribution $D_T$ may be more than 0.2%.

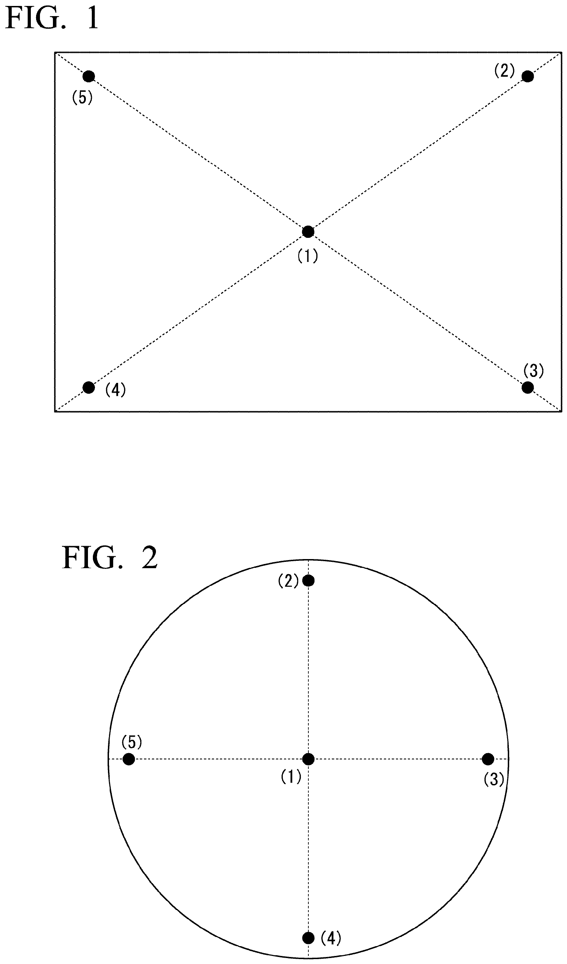

In a case of a sputtering target with a sputtering surface with a rectangular shape as shown in Fig. 1, the amounts of the additive elements are preferably measured and calculated at a plurality of locations on the sputtering surface, including at least five points of an intersection point (1) where diagonal lines intersect and the corner parts (2), (3), (4), and (5) on each diagonal line. The corner parts (2), (3), (4), and (5) are set to a range of 10% or less of the total diagonal line length from the corner parts to the inside.

In addition, in a case of a sputtering target with a sputtering surface with a circular shape as shown in Fig. 2, the amounts of the additive elements are preferably measured at a plurality of locations on the sputtering surface, including at least five points of the center of the circle (1) and outer periphery portions (2), (3), (4), and (5) on two straight lines passing through the center of the circle and orthogonal to each other. The outer periphery portions (2), (3), (4), and (5) are set to a range of 10% or less of the diameter from the outer edge to the inside.

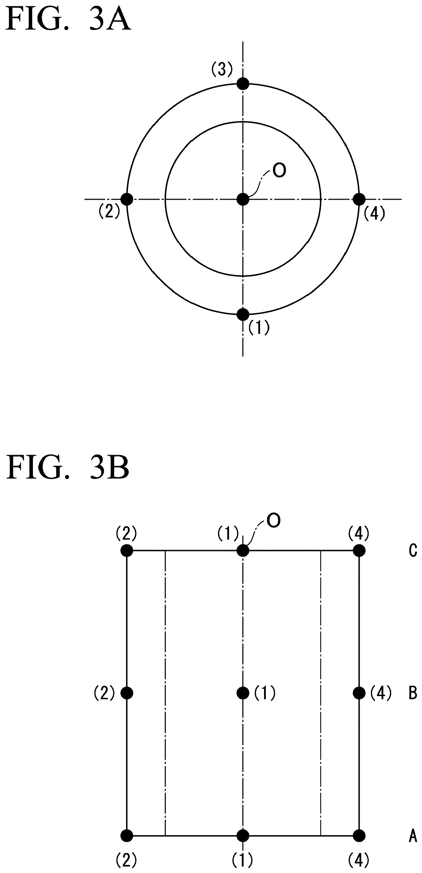

Furthermore, as shown in Fig. 3A and Fig. 3B, in a cylindrical type sputtering target in which the sputtering surface is a cylindrical surface, the amounts of the additive elements are preferably measured at a plurality of locations including at least a total twelve points of (1), (2), (3), and (4) at 90° intervals in the outer circumferential direction for each of one end portion, the central portion, and the other end portion in the axis direction. One end portion in the axis direction and the other end portion in the axis direction are set to a range of 10% or less of the total length of the axis direction from the end portions in the axis direction to the inside.

<Method for Manufacturing Sputtering Target>

Next, an explanation will be given of the method for manufacturing a sputtering target of the present embodiment.

First, an Ag raw material in which the amounts of Pd, Pt, Au, and Rh are reduced is prepared.

In the present embodiment, electro-deposited Ag was prepared by carrying out electrolytic refining on Ag with a purity of 99.9% by mass or higher and the obtained electro-deposited Ag was re-cast as an anode for electrolysis and electrolysis is conducted again. By repeating the above, the concentration of impurities in the Ag was reduced. In addition, component analysis was carried out by ICP optical emission spectrometry after each time electrolytic refining was carried out.

Due to this, an Ag raw material is obtained in which the Pd content is 40 mass ppm or less, the Pt content is 20 mass ppm or less, the Au content is 20 mass ppm or less, and the Rh content is 10 mass ppm or less, and the total amount of Pd, Pt, Au, and Rh is 50 mass ppm or less.

In addition, in a case where Sb, Zn, Sn, Pb, and Ti as additive elements are contained, Sb raw material, Zn raw material, Sn raw material, Pb raw material, and Ti raw material each with a purity of 99.9% by mass or higher are prepared. The Ag matrix alloy containing Sb, Zn, Sn, Pb, and Ti may be used as the raw material.

Next, using a melting furnace, the Ag raw material is dissolved under a high vacuum or inert gas atmosphere, and the Sb raw material, Zn raw material, Sn raw material, Pb raw material, and Ti raw material are added to the obtained Ag molten metal as necessary. After that, the result is dissolved in a high vacuum or inert gas atmosphere. Here, it is preferable to dissolve the result in a high-frequency induction heating furnace in which it is possible to stir the molten metal with high frequency in order to make the concentration of the additive elements in the ingot uniform.

In addition, preferably, the dissolution of the Ag raw material is performed in an atmosphere where the inside of the melting furnace is made to be a high vacuum one time and then replaced with Ar, and, after the dissolution, a secondary raw material is introduced in the Ar atmosphere.

The Ag molten metal is then poured into a mold with a predetermined shape to create an Ag ingot. When casting the Ag molten metal, it is preferable to quench the Ag molten metal by pouring the Ag molten metal into a water-cooled mold in order to eliminate segregation of the additive elements as much as possible.

Subsequently, the obtained Ag ingot is forged and rolled. The rolling is carried out by hot rolling or cold rolling.

In a case where hot rolling is used, it is preferable to perform a heat treatment under conditions of holding the temperature at 600°C or higher and 700°C or lower for 1 hour or more and 10 hours or less, as a homogenizing heat treatment step prior to the start of rolling. When the temperature is lower than 600°C, there is a concern that homogenization may be insufficient, and when the temperature exceeds 700°C, there is a concern that a liquid phase may appear in the ingot and the target may be softened or dissolved. In addition, when the heat treatment time is less than 1 hour, there is a concern that the homogenization may be insufficient, and when more than 10 hours, there is a concern that internal oxidation may occur.

There are no particular limitations on the atmosphere in the homogenizing heat treatment step described above; for example, which may be an atmospheric atmosphere or an inert gas atmosphere.

After the homogenizing heat treatment step, hot rolling is performed and the temperature at the end of rolling is preferably 400°C or higher and 700°C or lower and intermediate annealing is preferably added in some cases.

During rolling, the cumulative pressure drop ratio is preferably 70% or higher and the pressure drop ratio for at least the final pass of rolling is preferably 20% or higher. When the pressure drop ratio is less than 20%, the refining of the crystal grain size is not sufficient and the crystal grain size in the inside is also insufficiently uniform. In addition, due to the relationship with the capacity of the rolling mill, a pressure drop ratio of 50% or more per pass is not practical.

After rolling, heat treatment is carried out to homogenize the crystal structure of the target material and to remove work hardening. The temperature at which the heat treatment is carried out is preferably a condition of being held in a range of 500°C or higher and 700°C or lower for 1 hour or more and 5 hours or less. When the temperature is lower than 500°C, the effect of the work hardening removal is insufficient while when the temperature exceeds 700°C, there is a concern that the crystal grains may become coarse, or a liquid phase may appear, causing the target to melt or soften. In addition, when the heat treatment time is less than 1 hour, the uniformity is insufficient. After the heat treatment, the target is quenched by air or water cooling.

There are no particular limitations on the atmosphere during the heat treatment described above and, for example, the atmosphere may be an atmospheric atmosphere or an inert gas atmosphere.

Then, cutting processing or the like is carried out to achieve the predetermined shape and dimensions.

By the steps described above, the sputtering target of the present embodiment is manufactured.

<Method for Manufacturing Metal Film>

Next, a description will be given of the method for manufacturing a metal film of the present embodiment.

It is possible to deposit the metal film of the present embodiment by sputtering using the sputtering target of the present embodiment described above.

The sputtering target described above is, for example, soldered to a backing plate formed of oxygen-free copper, mounted on the sputtering apparatus, and the film is sputtered and deposited onto the surface of the substrate.

The sputtering apparatus used here may be a stationary facing type which sputters while the substrate on which the metal film is to be deposited is stationary, or may be a substrate transport type (in-line type) which sputters while transporting the substrate.

In addition, as the power supply for the sputtering apparatus, for example, it is possible to use a direct current (DC) power supply, a radio frequency (RF) power supply, a medium frequency (MF) power supply, or an alternating current (AC) power supply.

According to the metal film of the present embodiment with the above configuration, the Pd content is 40 mass ppm or less, the Pt content is 20 mass ppm or less, the Au content is 20 mass ppm or less, the Rh content is 10 mass ppm or less, the total amount of Pd, Pt, Au, and Rh is 50 mass ppm or less, and the balance is formed of Ag and inevitable impurities, thus, the amounts of elements such as Pd, Pt, Au, and Rh, which act as catalysts in the reduction reaction of nitric acid, are limited, and, even in a case of carrying out an etching treatment using an etchant including nitric acid such as PAN, it is possible to suppress the dissolution reaction of Ag from progressing more than is necessary and to control the etching rate. Thus, it is possible to stably control the etching state and to form a pattern shape with good precision.

Furthermore, in the metal film of the present embodiment, in a case where at least one or more of Sb, Zn, Sn, Pb, and Ti as additive elements are contained in a range of 0.05 atom% or more and 5.00 atom% or less in total, the additive elements described above act as catalytic poisons which suppress the reduction reaction of nitric acid so as to further control the reduction reaction of nitric acid, such that it is possible to suppress the dissolution reaction of Ag from progressing more than is necessary and to further control the etching rate.

In the sputtering target of the present embodiment, the Pd content is 40 mass ppm or less, the Pt content is 20 mass ppm or less, the Au content is 20 mass ppm or less, the Rh content is 10 mass ppm or less, the total amount of Pd, Pt, Au, and Rh is 50 mass ppm or less, and the balance is formed of Ag and inevitable impurities, thus, as described above, even in a case of carrying out an etching treatment using an etchant including nitric acid such as PAN, it is possible to deposit a metal film for which it is possible to control the etching rate.

Furthermore, in a case where when the sputtering target of the present embodiment contains at least one or more of Sb, Zn, Sn, Pb, and Ti as additive elements in a range of 0.05 atom% or more and 5.00 atom% or less in total, even in a case of carrying out an etching treatment using an etchant including nitric acid such as PAN, it is possible to deposit a metal film for which it is possible to further control the etching rate.

In the sputtering target of the present embodiment, in a case where at least one or more of Sb, Zn, Sn, Pb, and Ti as additive elements are contained in a range of 0.05 atom% or more and 5.00 atom% or less in total and the distribution $D_T$ calculated from the average value $\mu_T$ and the standard deviation $\sigma_T$ of total amount values of Sb, Zn, Sn, Pb, and Ti at a plurality of measurement points on a sputtering surface is 20% or less, these additive elements are uniformly present on the sputtering surface, it is possible to deposit a metal film in which these additive elements are uniformly dispersed, and it is possible to stabilize the etching rate over the entire metal film.

Although embodiments of the present invention were described above, the present invention is not limited thereto and is able to be modified as appropriate in a range not departing from the technical concept of the invention.

The metal film of the present invention may be used as a single film or may be used as a multilayer film with other films such as conductive oxide films.

In addition, in the present embodiment, a description was given of manufacturing a sputtering target by hot rolling and cold rolling an Ag ingot; however, without being limited thereto, other processing methods such as hot forging may be applied thereto. As the processing method, it is preferable to appropriately select a known method according to the shape of the sputtering target to be manufactured.

[Examples]

A description will be given below of the results of confirmation experiments performed to confirm the effectiveness of the present invention.

By repeatedly carrying out electrolytic refining and carrying out component analysis using ICP optical emission spectrometry, Ag raw materials were obtained in which the Pd content was 40 mass ppm or less, the Pt content was 20 mass ppm or less, the Au content was 20 mass ppm or less, the Rh content was 10 mass ppm or less, and the total amount of Pd, Pt, Au, and Rh was 50 mass ppm or less. For Comparative Examples 1 to 6, Ag raw materials in which the amounts of the elements described above were not limited were used.

The Ag raw material was dissolved under a vacuum atmosphere, which was then replaced with Ar gas, then, a Sb raw material, a Zn raw material, a Sn raw material, a Pb raw material, and a Ti raw material with purity of 99.9% by mass or higher were added as necessary to smelt Ag molten metal with a predetermined composition. The Ag molten metal was then cast to manufacture Ag ingots.

(Component Composition)

An analytical sample was taken from the obtained Ag ingot and the component composition was measured by ICP optical emission spectrometry. The measurement results are shown in Table 1 as the component composition of the Ag sputtering target.

In Table 1, the amounts of elements (catalytic elements) such as Pd, Pt, Au, and Rh, which act as catalysts in the reduction reaction of nitric acid, are indicated as a mass ratio and the amounts of additive elements (Sb, Zn, Sn, Pb, and Ti) are indicated as an atomic ratio.

Hot rolling was carried out on the obtained Ag ingots. The rolling start temperature was set to 650°C, the rolling end temperature was set to 400°C, and the cumulative pressure drop ratio was set at 80%.

After hot rolling, the ingots were subjected to a heat treatment under conditions of 600°C for 1 hour. After heat treatment, the ingots were quenched by water cooling.

As a result of the above, a sheet material with a length of 2000 mm, a width of 200 mm, and a thickness of 8 mm was obtained.

(Distribution of Additive Elements)

The average value $\mu_T$, the standard deviation $\sigma_T$, and the distribution $D_T$ of the total amounts of the additive elements on the sputtering surface of the obtained sheet material were measured as follows.

Measurement samples were taken from the positions shown in Fig. 1 and the total amount of the additive elements was measured by ICP-MS analysis using each measurement sample.

The average value $\mu_T$ and standard deviation $\sigma_T$ of the total amount of the additive elements for the sputtering target as a whole were calculated from the total amounts of the additive elements obtained from the measurement samples at each of the five locations.

Then, using the average value $\mu_T$ and standard deviation $\sigma_T$, the distribution $D_T = (\sigma_T/\mu_T) \times 100$ (%) was calculated. The measurement results are shown in Table 1.

Next, a sputtering target with predetermined dimensions (126 mm x 178 mm x 6 mm thick) was produced by cutting and machining the sheet material described above.

The sputtering target obtained as described above was soldered to a backing plate formed of oxygen-free copper and then mounted on a sputtering apparatus. In the present embodiment, a magnetron DC sputtering apparatus was used. In addition, in the present embodiment, a substrate transport type sputtering apparatus which sputters while transporting the substrate was used.

Then, the metal film was deposited on a glass substrate (EAGLE XG manufactured by Corning Inc.) by sputtering under the following conditions.

Deposition start vacuum level: $1.0 \times 10^{-4}$ Pa or less
Sputtering gas: High-purity argon
Sputtering gas pressure in chamber: 0.4 Pa
DC power: 100 W

(Composition of Metal Film)

Under the conditions described above, a metal film was deposited on a glass substrate with a thickness of 1000 nm and the component composition of the film was measured by ICP optical emission spectrometry. As a result, it was confirmed that the composition was the same as the composition of the sputtering target, for Examples 1 to 23 of the present invention, the Pd content was 40 mass ppm or less, the Pt content was 20 mass ppm or less, the Au content was 20 mass ppm or less, the Rh content was 10 mass ppm or less, and the total amount of Pd, Pt, Au, and Rh was 50 mass ppm or less, and, for Examples 6 to 23, the total amount of Sb, Zn, Sn, Pb, and Ti was 0.05 atom% or more and 5.00 atom% or less.

(Film Thickness Measurement)

Under the conditions described above, a metal film with a thickness of 100 nm was deposited on a glass substrate. In a case where the film was deposited by sputtering, the sputtering rate was measured by measuring the film thickness by means of a step measurement meter (DEKTAK-XT) when depositing for a certain period of time and the deposition time was adjusted based on this value to carry out the deposition at the target thickness.

The actual metal film was confirmed by observing the cross-section of the metal film using a transmission electron microscope (TEM) and it was confirmed that the film thickness was deposited according to the target value. For example, it is possible to use a cross-section polisher (CP) or a focused ion beam (FIB) to prepare samples for TEM observation.

The metal films deposited as described above were then evaluated for electrical characteristics and etching characteristics as follows.

(Electrical Characteristics Evaluation)

The sheet resistance of the metal film was measured by a four-probe method using a resistance measuring instrument LORESTA GP manufactured by Mitsubishi Chemical.

(Etching Characteristics Evaluation)

First, a wiring pattern was formed by photolithography on a metal film of 100 nm thickness deposited on a glass substrate. A photoresist agent (OFPR-8600 manufactured by Tokyo Ohka Kogyo Co., Ltd.) was coated thereon by a spin coater, the result was pre-baked at 110°C and then exposed, after which the pattern was developed using a developer (NMD-W manufactured by Tokyo Ohka Kogyo Co., Ltd.) and post-baking was performed at 150°C. Due to this, a comb-shaped wiring pattern with a width of 100 $\mu$m and a spacing of 100 $\mu$m was formed on the Ag alloy film.

Wet etching was carried out on the film described above. As the etchant, SEA-2 manufactured by Kanto Chemical Co., Inc. was used and the etching was performed at a liquid temperature of 40°C for an immersion time of 30 seconds.

For the wiring film obtained as described above, the substrate was cleaved to observe the wiring cross-section and the cross-section was observed using a scanning electron microscope (SEM). Then, the difference between the parallel positions of the Ag film edge and the photoresist edge observed by SEM was measured as the amount of over-etching of the Ag film.

[Table 1]

| | | Composition of Target | | | | | | | | | | | Ag | Distribution $D_T$ of additive elements (%) |
|---|---|---|---|---|---|---|---|---|---|---|---|---|---|---|
| | | Catalyst elements (mass ppm) | | | | | Additive elements (atom%) | | | | | | | |
| | | Pd | Pt | Au | Rh | Total | Sb | Zn | Sn | Pb | Ti | Total | | |
| Examples | 1 | 2.0 | 1.0 | 1.0 | <1.0 | <5.0 | - | - | - | - | - | - | Balance | - |
| | 2 | 35.0 | 4.0 | 5.0 | 3.0 | 47.0 | - | - | - | - | - | - | Balance | - |
| | 3 | 5.0 | 18.0 | 2.0 | 1.0 | 26.0 | - | - | - | - | - | - | Balance | - |
| | 4 | 4.0 | 4.0 | 18.0 | 1.0 | 27.0 | - | - | - | - | - | - | Balance | - |
| | 5 | 11.0 | 11.0 | 11.0 | 9.0 | 42.0 | - | - | - | - | - | - | Balance | - |
| | 6 | 1.0 | 1.0 | 1.0 | 1.0 | 4.0 | 0.05 | - | - | - | - | 0.05 | Balance | 13 |
| | 7 | 2.0 | <1.0 | <1.0 | <1.0 | <5.0 | 1.95 | - | - | - | - | 1.95 | Balance | 4 |
| | 8 | 1.0 | <1.0 | <1.0 | <1.0 | <4.0 | 4.90 | - | - | - | - | 4.90 | Balance | 3 |
| | 9 | 1.0 | <1.0 | <1.0 | <1.0 | <4.0 | - | 0.05 | - | - | - | 0.05 | Balance | 12 |
| | 10 | 1.0 | <1.0 | <1.0 | <1.0 | <4.0 | - | 1.45 | - | - | - | 1.45 | Balance | 5 |
| | 11 | 1,0 | <1.0 | <1.0 | <1.0 | <4.0 | - | 5.00 | - | - | - | 5.00 | Balance | 4 |
| | 12 | 2.0 | <1.0 | <1.0 | <1.0 | <5.0 | - | - | 0.06 | - | - | 0.06 | Balance | 15 |
| | 13 | 1.0 | 1.0 | 1.0 | <1.0 | <4.0 | - | - | 2.04 | - | - | 2.04 | Balance | 4 |
| | 14 | 1.0 | <1.0 | <1.0 | <1.0 | <4.0 | - | - | 4.98 | - | - | 4.98 | Balance | 4 |
| | 15 | 2.0 | <1.0 | <1.0 | <1.0 | <5.0 | - | - | - | 0.05 | - | 0.05 | Balance | 16 |
| | 16 | <1.0 | <1.0 | <1.0 | <1.0 | <4.0 | - | - | - | 2.00 | - | 2.00 | Balance | 5 |
| | 17 | <1.0 | <1.0 | <1.0 | <1.0 | <4.0 | - | - | - | 5.00 | - | 5.00 | Balance | 4 |
| | 18 | 1.0 | <1.0 | <1.0 | <1.0 | <4.0 | - | - | - | - | 0.05 | 0.05 | Balance | 19 |
| | 19 | <1.0 | 1.0 | <1.0 | <1.0 | <4.0 | - | - | - | - | 1.80 | 1.80 | Balance | 2 |
| | 20 | <1.0 | <1.0 | <1.0 | <1.0 | <4.0 | - | - | - | - | 4.90 | 4.90 | Balance | 2 |
| | 21 | 1.0 | <1.0 | <1.0 | <1.0 | <4.0 | - | 0.45 | 0.50 | - | - | 0.95 | Balance | 6 |
| | 22 | 1.0 | <1.0 | <1.0 | <1.0 | <4.0 | - | 2.96 | 2.01 | - | - | 4.97 | Balance | 4 |
| | 23 | 2.0 | 1.0 | 1.0 | 1.0 | 5.0 | - | 0.95 | 0.80 | - | 1.00 | 2.75 | Balance | 4 |

| | | Composition of Target | | | | | | | | | | | Ag | Distribution $D_T$ of additive elements (%) |
|---|---|---|---|---|---|---|---|---|---|---|---|---|---|---|
| | | Catalyst elements (mass ppm) | | | | | Additive elements (atom%) | | | | | | | |
| | | Pd | Pt | Au | Rh | Total | Sb | Zn | Sn | Pb | Ti | Total | | |
| Comparative Examples | 1 | 55.0 | 1.0 | 1.0 | <1.0 | 57.0 | - | - | - | - | - | - | Balance | - |
| | 2 | 1.0 | 26.0 | 1.0 | 1.0 | 29.0 | - | - | - | - | - | - | Balance | - |
| | 3 | 2.0 | <1.0 | 25.0 | <1.0 | 27.0 | - | - | - | - | - | - | Balance | - |
| | 4 | 1.0 | <1.0 | <1.0 | 15.0 | 16.0 | - | - | - | - | - | - | Balance | - |
| | 5 | 18.0 | 17.0 | 15.0 | 6.0 | 56.0 | - | - | - | - | - | - | Balance | - |
| | 6 | 105.0 | 66.0 | 22.0 | 12.0 | 205.0 | - | - | - | - | - | - | Balance | - |
| | 7 | 1.0 | <1.0 | <1.0 | <1.0 | <4.0 | 7.50 | - | - | - | - | 7.50 | Balance | 4 |
| | 8 | 2.0 | <1.0 | <1.0 | <1.0 | <5.0 | - | 8.50 | - | - | - | 8.50 | Balance | 3 |
| | 9 | 1.0 | 1.0 | 1.0 | <1.0 | <4.0 | - | - | 7.05 | - | - | 7.05 | Balance | 3 |
| | 10 | 2.0 | <1.0 | <1.0 | <1.0 | <5.0 | - | - | - | 6.52 | - | 6.52 | Balance | 2 |
| | 11 | <1.0 | <1.0 | <1.0 | <1.0 | <4.0 | - | - | - | | 6.47 | 6.47 | Balance | 4 |

[Table 2]

| | | Sputtering target used | Sheet resistance ($\Omega$/sq) | Over-etching amount ($\mu$m) |
|---|---|---|---|---|
| Examples | 101 | Example 1 | 0.26 | 0.7 |
| | 102 | Example 2 | 0.26 | 0.8 |
| | 103 | Example 3 | 0.26 | 0.8 |
| | 104 | Example 4 | 0.26 | 0.8 |
| | 105 | Example 5 | 0.26 | 0.7 |
| | 106 | Example 6 | 0.30 | 0.6 |
| | 107 | Example 7 | 0.48 | 0.3 |
| | 108 | Example 8 | 0.75 | 0.2 |
| | 109 | Example 9 | 0.31 | 0.5 |
| | 110 | Example 10 | 0.50 | 0.3 |
| | 111 | Example 11 | 0.89 | 0.2 |
| | 112 | Example 12 | 0.32 | 0.6 |
| | 113 | Example 13 | 0.60 | 0.4 |
| | 114 | Example 14 | 0.93 | 0.2 |
| | 115 | Example 15 | 0.32 | 0.6 |
| | 116 | Example 16 | 0.65 | 0.4 |
| | 117 | Example 17 | 0.96 | 0.2 |
| | 118 | Example 18 | 0.33 | 0.3 |
| | 119 | Example 19 | 0.59 | 0.3 |
| | 120 | Example 20 | 0.97 | 0.1 |
| | 121 | Example 21 | 0.50 | 0.4 |
| | 122 | Example 22 | 0.91 | 0.1 |
| | 123 | Example 23 | 0.69 | 0.2 |
| Comparative Examples | 101 | Comparative Example 1 | 0.26 | 1.7 |
| | 102 | Comparative Example 2 | 0.26 | 1.8 |
| | 103 | Comparative Example 3 | 0.26 | 1.6 |
| | 104 | Comparative Example 4 | 0.26 | 1.6 |
| | 105 | Comparative Example 5 | 0.27 | 3.0 |
| | 106 | Comparative Example 6 | 0.26 | 3.3 |
| | 107 | Comparative Example 7 | 1.17 | 0.3 |
| | 108 | Comparative Example 8 | 1.25 | 0.1 |
| | 109 | Comparative Example 9 | 1.18 | 0.2 |
| | 110 | Comparative Example 10 | 1,30 | 0.3 |
| | 111 | Comparative Example 11 | 1.31 | 0.2 |

In Comparative Example 101 deposited using a sputtering target of Comparative Example 1 with a Pd content of 55.0 mass ppm, Comparative Example 102 deposited using a sputtering target of Comparative Example 2 with a Pt content of 26.0 mass ppm, Comparative Example 103 deposited using a sputtering target of Comparative Example 3 with an Au content of 25.0 mass ppm, and Comparative Example 104 deposited using a sputtering target of Comparative Example 4 with a Rh content of 15.0 mass ppm, the amount of over-etching was as large as 1.6 to 1.8 μm and the etching characteristics were insufficient.

In addition, in Comparative Example 105 deposited using the sputtering target of Comparative Example 5, in which the total amount of Pd, Pt, Au, and Rh was 56.0 mass ppm and Comparative Example 106 deposited using the sputtering target of Comparative Example 6, in which the total amount of Pd, Pt, Au, and Rh was 205.0 mass ppm, the amount of over-etching was even larger at 3.0 to 3.3 μm and the etching characteristics were insufficient.

Furthermore, in Comparative Examples 107 to 111 deposited using the sputtering targets of Comparative Examples 7 to 11 in which the total amount of the additive elements Sb, Zn, Sn, Pb, and Ti was more than 5.00 atom%, the sheet resistance was high in all cases and it was not possible to ensure the electrical characteristics of the metal films.

In contrast, in Examples 101 to 105 of the present invention deposited using the sputtering targets of Examples 1 to 5 with a composition in which the Pd content was 40 mass ppm or less, the Pt content was 20 mass ppm or less, the Au content was 20 mass ppm or less, the Rh content was 10 mass ppm or less, the total amount of Pd, Pt, Au, and Rh was 50 mass ppm or less, and the balance was Ag and inevitable impurities, the amount of over-etching was controlled to be low and the etching characteristics were excellent. In addition, the sheet resistance was sufficiently low and it was possible to ensure the electrical characteristics of the metal film.

In addition, in Examples 106 to 123 of the present invention deposited using the sputtering targets of Examples 6 to 23 in which the Pd content was 40 mass ppm or less, the Pt content was 20 mass ppm or less, the Au content was 20 mass ppm or less, the Rh content was 10 mass ppm or less, the total amount of Pd, Pt, Au, and Rh was 50 mass ppm or less, and at least one or more of Sb, Zn, Sn, Pb, and Ti as additive elements were contained in a range of 0.05 atom% or more and 5.00 atom% or less in total, the amount of over-etching was further controlled to be low and the etching characteristics were excellent. The sheet resistance was also low and it was possible to ensure the electrical characteristics of the metal film.

From the above, it was confirmed that, according to the Examples, it is possible to provide a metal film for which it is possible to control the etching rate even in a case of using an etchant including nitric acid and with which it is possible to carry out an etching treatment with good precision, and a sputtering target used when depositing this metal film.

[Industrial Applicability]

According to the present invention, it is possible to provide a metal film for which it is possible to control the etching rate even in a case of using an etchant including nitric acid and with which it is possible to carry out an etching treatment with good precision, and a sputtering target used when depositing this metal film.

## Claims

1.  A metal film wherein

    a Pd content is 40 mass ppm or less,
    a Pt content is 20 mass ppm or less,
    a Au content is 20 mass ppm or less,
    a Rh content is 10 mass ppm or less,
    a total amount of Pd, Pt, Au, and Rh is 50 mass ppm or less, and
    a balance consists of Ag and inevitable impurities.

2.  The metal film according to Claim 1, comprising one or more of Sb, Zn, Sn, Pb, and Ti in a range of 0.05 atom% or more and 5.00 atom% or less in total as additive elements.

3.  A sputtering target wherein

    a Pd content is 40 mass ppm or less,
    a Pt content is 20 mass ppm or less,
    a Au content is 20 mass ppm or less,
    a Rh content is 10 mass ppm or less,
    a total amount of Pd, Pt, Au, and Rh is 50 mass ppm or less; and
    a balance consists of Ag and inevitable impurities.

4.  The sputtering target according to Claim 3,
    comprising one or more of Sb, Zn, Sn, Pb, and Ti in a range of 0.05 atom% or more and 5.00 atom% or less in total as additive elements.

5. The sputtering target according to Claim 4,
   wherein a distribution $D_T$ is 20% or less, the Distribution $D_T$ being calculated from an average value $\mu_T$ and a standard deviation $\sigma_T$ of total amount values of Sb, Zn, Sn, Pb, and Ti at a plurality of measurement points on a sputtering surface by using a formula below,

$$D_T = (\sigma_T/\mu_T) \times 100 \ (\%).$$

FIG. 1

FIG. 2

FIG. 3A

FIG. 3B

## INTERNATIONAL SEARCH REPORT

| International application No. |
| --- |
| PCT/JP2019/047603 |

### A. CLASSIFICATION OF SUBJECT MATTER

Int.Cl. C23C14/14(2006.01)i, C22C5/06(2006.01)i, C23C14/34(2006.01)i, G02F1/1335(2006.01)i, G02F1/1343(2006.01)i, C22F1/00(2006.01)n, C22F1/14(2006.01)n

According to International Patent Classification (IPC) or to both national classification and IPC

### B. FIELDS SEARCHED

Minimum documentation searched (classification system followed by classification symbols)

Int.Cl. C23C14/14, C22C5/06, C23C14/34, G02F1/1335, G02F1/1343, C22F1/00, C22F1/14

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

JSTPlus/JSTChina/JST7580(JDreamIII)

### C. DOCUMENTS CONSIDERED TO BE RELEVANT

| Category* | Citation of document, with indication, where appropriate, of the relevant passages | Relevant to claim No. |
| --- | --- | --- |
| X | WO 2014/097943 A1 (TORAY INDUSTRIES, INC.) 26 June 2014, paragraphs [0061], [0062], [0065] & US 2015/0293025 A1, paragraphs [0091], [0092], [0096] & TW 201433539 A | 1, 3 |
| X | CN 103243305 A (LANZHOU INSTITUTE OF PHYSICS) 14 August 2013, paragraphs [0030]-[0035] (Family: none) | 1, 3 |
| X | JP 6-279992 A (TANAKA KIKINZOKU KOGYO KK) 04 October 1994, paragraphs [0001]-[0003], [0007]-[0010] (Family: none) | 1 |

☒ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 19.12.2019 | 07.01.2020 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

**INTERNATIONAL SEARCH REPORT**

International application No.

PCT/JP2019/047603

C (Continuation). DOCUMENTS CONSIDERED TO BE RELEVANT

| Category* | Citation of document, with indication, where appropriate, of the relevant passages | Relevant to claim No. |
|---|---|---|
| X | WO 2016/136590 A1 (MITSUBISHI MATERIALS CORPORATION) 01 September 2016, claims 1-6, paragraphs [0001], [0028]-[0062] & JP 2016-164305 A & US 2017/0191154 A1, claims 1-6, paragraphs [0001], [0054]-[0108] & EP 3196334 A1 & KR 10-2016-0143865 A & CN 106414793 A & TW 201704481 A | 2, 4, 5 |
| X | JP 2017-31503 A (MITSUBISHI MATERIALS CORPORATION) 09 February 2017, claims 1-12, paragraphs [0001], [0009]-[0097] & WO 2017/018310 A1 & TW 201718886 A & CN 107709584 A & KR 10-2018-0034334 A | 2, 4, 5 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018228365 A
- JP 2006028641 A
- JP 6020750 B
- JP 2017179594 A
- JP 2017183274 A